# FASCICULE DE BREVET EUROPEEN

(11) **EP 3 413 419 B1**
(45) Date de publication et mention de la délivrance du brevet: **21.08.2019**
(21) Numéro de dépôt: 18172246.3
(22) Date de dépôt: 15.05.2018
(51) Int. Cl.: H02H 3/20, G01R 31/02, H02H 7/22

(54) **LIAISON ÉLECTRIQUE COMPRENANT UN DISPOSITIF DE PROTECTION ÉLECTRIQUE - TEST D'INTÉGRITÉ**
ELEKTRISCHE SCHALTUNG MIT ELEKTRISCHER SCHUTZEINRICHTUNG - INTEGRITÄTSTEST
ELECTRICAL CIRCUIT WITH ELECTRICAL PROTECTION DEVICE - INTEGRITY TEST

(30) Priorité: 08.06.2017 FR 1755085
(43) Date de publication de la demande: 12.12.2018
(73) Titulaire: Airbus Operations S.A.S., 31060 Toulouse (FR)
(72) Inventeur: OMS, Patrick, 31770 COLOMIERS (FR)
(74) Mandataire: Gicquel, Olivier Yves Gérard

(56) Documents cités:
- FR-A1- 2 781 574
- US-A1- 2002 041 187
- US-A1- 2003 042 913

## Description

### DOMAINE TECHNIQUE

La présente invention concerne une liaison électrique pour la transmission d'une haute tension à courant continu à un équipement utilisateur, ladite liaison comprenant un dispositif de protection électrique pour fournir l'énergie électrique de manière sécurisée.

### ETAT DE LA TECHNIQUE

Une installation électrique d'un aéronef comprend classiquement une source d'alimentation électrique reliée à un équipement utilisateur à alimenter en énergie électrique via une liaison électrique formée d'un conducteur électrique recouvert d'une enveloppe isolante. La liaison électrique comprend un dispositif de type disjoncteur pour surveiller les paramètres du signal électrique transitant via la liaison entre la source d'alimentation et l'équipement utilisateur afin d'interrompre un courant de surcharge ou un courant de court-circuit dans le conducteur.

La puissance électrique consommée dans les aéronefs est en constante augmentation. Cette évolution conduit inévitablement à une élévation des niveaux de tension des systèmes d'alimentation électrique dans les aéronefs qui étaient classiquement de 115 AC (AC pour alternative current : courant alternatif) et 28 Volts DC (DC pour direct current : courant continu).

Des tensions de l'ordre de +/- 270 Volts DC ou 540Volts DC sont aujourd'hui considérées.

De telles valeurs de tensions font apparaître de nouvelles problématiques dans les aéronefs. Par exemple, la sécurité du personnel de maintenance doit être assurée en cas de déconnexion ou de rupture de la liaison électrique.

Les dispositifs de type disjoncteur de l'art antérieur ne sont pas adaptés à détecter une rupture de la continuité électrique d'une liaison électrique.

### EXPOSE DE L'INVENTION

Il existe un besoin de trouver un dispositif de protection électrique d'une liaison électrique permettant de sécuriser la fourniture en énergie électrique à haute tension à un équipement utilisateur d'un véhicule, surmontant tout ou en partie l'inconvénient de l'art antérieur susmentionné.

A cet effet, l'invention concerne une liaison électrique adaptée à relier une source d'énergie haute tension à courant continu à un équipement utilisateur, la liaison électrique comprenant un conducteur électrique entouré d'une enveloppe isolante, la liaison électrique comprenant un dispositif de protection électrique comprenant :
- une gaine conductrice arrangée autour de l'enveloppe isolante,
- un coupe-circuit arrangé sur le conducteur électrique et configuré pour couper un courant transitant via ledit conducteur,
caractérisé en ce que le dispositif de protection comprend en outre :
- un module de polarisation configuré pour polariser en tension la gaine conductrice avec une tension continue, dite tension de test ;
- un dispositif de limitation de la tension de polarisation de la gaine conductrice ayant une tension de limitation inférieure à la tension de test ;
- un module de détection connecté à la gaine conductrice et configuré pour détecter une limitation ou non de la tension de polarisation de la gaine conductrice par le dispositif de limitation et pour commander le coupe-circuit en fonction de la détection.

Ainsi, il est possible de sécuriser la fourniture en énergie électrique à haute tension à un équipement utilisateur d'un véhicule et d'assurer la sécurité du personnel de maintenance en cas de déconnexion ou de rupture de la liaison électrique.

Selon un mode particulier, le module de polarisation comprend une source de tension continue fournissant la tension de test connectée à la gaine conductrice.

Selon un mode particulier, le module de détection comprend :
- un comparateur dont une première entrée est connectée à la gaine conductrice et dont une seconde entrée est connectée à un générateur de tension continue fournissant une tension dite de référence ;
- un microcontrôleur connecté entre une sortie du comparateur et le coupe-circuit, le microcontrôleur étant configuré pour envoyer un signal de commande au coupe-circuit en fonction d'un signal de sortie reçu du comparateur.

Selon un mode particulier, une enveloppe isolante entoure la gaine conductrice.

### BREVE DESCRIPTION DES DESSINS

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
- la figure 1 représente un aéronef comportant une installation électrique ayant une source d'alimentation connectée à un équipement utilisateur via une liaison électrique et une ligne de retour de courant et un dispositif de protection électrique de la liaison électrique selon un mode de réalisation de l'invention ;
- la figure 2 représente un schéma bloc de l'installation électrique représentée à la figure 1, et une représentation du dispositif de protection électrique de la liaison électrique selon un mode de réalisation de l'invention ;
- la figure 3 représente une vue schématique d'une gaine conductrice arrangée sur une liaison électrique et formant une partie du dispositif de protection électrique selon l'invention ;
- la figure 4 représente un schéma électrique de l'installation électrique représentée à la figure 2 ;
- la figure 5 est un diagramme illustrant l'évolution de tensions sur la gaine conductrice selon la figure 3.

### EXPOSE DETAILLE DE MODES DE REALISATION

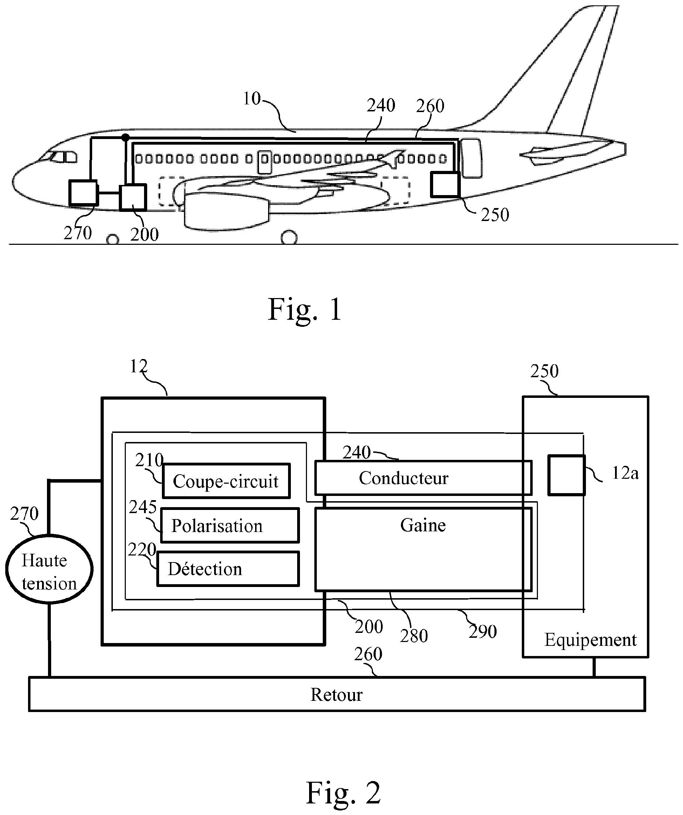

En relation avec la figure 1, un aéronef 10 comporte une installation électrique ayant une source d'alimentation électrique 270 en haute tension connectée à un équipement utilisateur 250 via une liaison électrique 290 comprenant un dispositif de protection électrique 200 associé à la liaison électrique 290.

La source d'alimentation électrique 270 est en outre reliée à l'équipement utilisateur 250 par une ligne de retour de courant 260.

La source d'alimentation électrique 270 en haute tension fournit une tension HV continue de l'ordre de + ou - 270 Volts DC, ou encore de 540 Volts DC.

L'aéronef 10 comprend en outre une structure conductrice (non représentée) qui est formée par tout élément métallique/conducteur de l'aéronef qui est au potentiel de référence et forme la masse.

En référence avec les figures 2 à 4, et selon l'invention, la liaison électrique 290 comprend un conducteur électrique 240 entouré d'une enveloppe isolante 320 (par exemple une gaine plastique), et le dispositif de protection électrique 200, configuré pour tester la continuité électrique de la gaine conductrice 280, comprend une partie arrangée sur l'enveloppe isolante 320 du conducteur 240 et une partie composée de dispositifs électroniques.

La partie arrangée sur l'enveloppe isolante 320 comprend une gaine conductrice 280 entourée d'une enveloppe isolante 310, la gaine conductrice 280 entourant l'enveloppe isolante 320 du conducteur 240.

La partie composée de dispositifs électroniques comprend par exemple, des dispositifs électroniques 210, 245, 220 arrangés dans un boîtier sécurisé 12 situé en amont (c'est-à-dire du côté de la source d'alimentation électrique 270) de la liaison électrique 290, et des dispositifs électroniques 250a arrangés dans un boîtier sécurisé 12a situé en aval (c'est-à-dire du côté de l'équipement utilisateur 250) de la liaison électrique 290. L'invention vise à tester l'intégrité mécanique/physique de la liaison électrique 290 à l'équipement utilisateur 250 via un test de continuité électrique de la gaine conductrice 280 sur une distance de test définie entre les dispositifs électroniques 210, 245, 220 arrangés dans le boîtier sécurisé 12 et les dispositifs électroniques 250a arrangés dans le boîtier sécurisé 12a. Par test de l'intégrité mécanique/physique, on entend la détection d'une rupture physique de la liaison électrique 290 ou une déconnexion de la liaison électrique 290 du boîtier sécurisé 12a, en particulier lorsque la liaison électrique 290 est réalisée en plusieurs pans connectés entre eux via des connecteurs (non représentés), la détection de l'ouverture de la liaison électrique 290 au niveau d'un connecteur.

De préférence, le boîtier sécurisé 12a est intégré à l'équipement utilisateur 250 permettant ainsi de détecter une déconnexion de la liaison électrique 290 de l'équipement utilisateur 250.

Les dispositifs électroniques arrangés dans le boîtier 12 (voir la figure 2) comprennent :
- un coupe-circuit 210 connecté à la source d'alimentation électrique 270 et qui, lorsqu'il est commandé en ce sens, permet d'interrompre la fourniture du signal HV à l'équipement utilisateur 250 via le conducteur électrique 240. De manière connue, le coupe-circuit 210 fonctionne comme un interrupteur qui, lorsqu'il est activé, s'ouvre et met ainsi le conducteur électrique 240 hors tension ;
- un module de polarisation 245 pour polariser en tension la gaine conductrice 280 ; et
- un module de détection 220 pour tester l'intégrité mécanique de la liaison électrique 290 via un test de continuité électrique de la gaine conductrice 280.

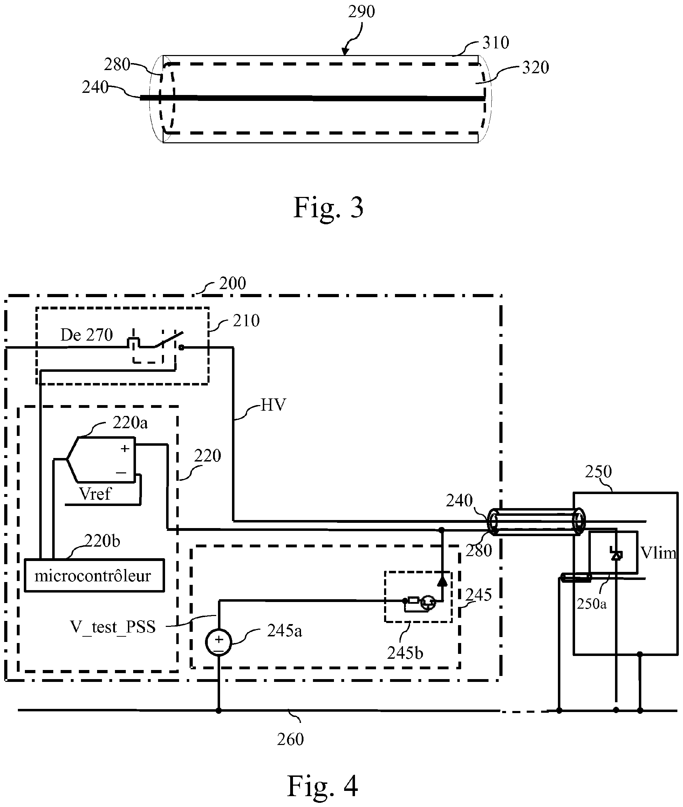

En référence avec la figure 4, le module de polarisation 245 comprend une source de tension continue 245a fournissant une tension V_test_PSS qui permet de polariser la gaine conductrice 280 avec la tension V_test_PSS.

Le module de polarisation 245 comprend en outre un circuit de protection 245b, tel que par exemple une résistance en série ou un limiteur de courant (le limiteur est représenté à la figure 4), qui a pour fonction de permettre la fluctuation de la tension V_test_PSS sur la gaine conductrice 280.

La source de tension 245a est connectée entre la ligne de retour de courant 260 et une première borne du circuit de protection 245b, une seconde borne dudit circuit étant connectée à la gaine conductrice 280.

La tension V_test_PSS délivrée par la source de tension 245a est non dangereuse pour les personnes physiques (< 50 Volts en valeur absolue).

Le module de détection 220 comprend un comparateur 220a ainsi qu'un microcontrôleur 220b reliant la sortie du comparateur 220a à l'entrée du coupe-circuit 210. Le microcontrôleur 220b reçoit un signal de sortie VComp du comparateur 220a et ce dernier est configuré pour fournir un signal de commande au coupe-circuit 210 afin de l'activer.

La gaine conductrice 280 est polarisée en permanence, et la surveillance de continuité de la gaine conductrice 280 est active en permanence.

Le comparateur 220a est connecté, sur une première entrée, à la gaine conductrice 280, et sur une seconde entrée, à un générateur de tension continue (non représenté) fournissant une tension, dite de référence, Vref.

Le comparateur 220a compare la tension V280 dans la gaine conductrice 280 à la tension de référence Vref de sorte à tester l'intégrité mécanique/physique de la liaison électrique 290. Le signal de sortie VComp du comparateur prend deux états, soit un premier état (par exemple 0 en logique booléenne) indicatif d'une absence de défaut d'intégrité physique/mécanique de la liaison électrique 290, soit un second état (par exemple 1) indicateur d'un défaut d'intégrité physique/mécanique de la liaison électrique 290 (déconnexion ou rupture de la liaison électrique).

La tension de référence Vref est choisie en fonction de la valeur de la tension Vlim du dispositif 250a, et en fonction de la valeur de la tension V_test_PSS.

Le dispositif électronique 250a arrangé dans le boîtier sécurisé 12a (voir la figure 2) a pour fonction de modifier le signal présent sur la gaine conductrice 280 si celui-ci dépasse un seuil prédéterminé. Par exemple, le dispositif électronique 250a est une diode limiteur de tension avec une tension de limitation Vlim choisie de sorte que le limiteur de tension limite la tension V_test_PSS fournie par la source de tension 245a. Ainsi, Vlim est inférieure à la tension V_test_PSS.

Une borne de la diode est connectée à une première terminaison à la gaine conductrice 280 et l'autre borne à la ligne de retour de courant 260.

L'entrée négative du comparateur 220a est reliée au générateur de tension continue qui fournit la tension de référence Vref choisie inférieure à la tension V_test_PSS tandis que l'entrée négative du comparateur 220a reçoit le signal V280.

Suivant cet exemple, la tension Vref est égale à 40 Volts pour V_test_PSS à 45 Volts et une tension de limitation Vlim à 35 Volts. Le signal de sortie VComp du comparateur 220a est dans premier état (par exemple de 0 en logique booléenne) tant que V280 est inférieure à Vref (lorsqu'il n'y a pas de défaut d'intégrité de la gaine 280), et passe dans le second état (par exemple 1) lorsque V280 est supérieure à Vref (ce qui indique une rupture de la continuité de la gaine conductrice 280, et donc potentiellement une déconnexion de la liaison électrique 290).

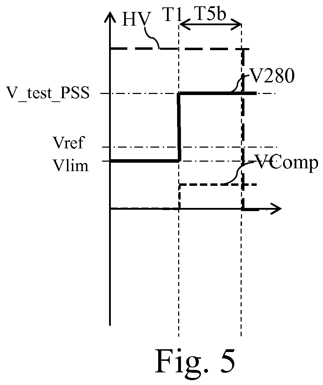

En relation avec la figure 5, il est représenté un exemple d'évolution des signaux Vref, V280, HV et VComp au cours du temps lorsque, à partir d'un temps T1, la liaison électrique 290 est déconnectée de l'équipement utilisateur 250, lequel comprend le boîtier sécurisé 12a.

Dans cet exemple, la source d'alimentation en haute tension 270 produit une tension HV positive :
HV=540 Volts,
Vref = 40 Volts,
V_test_PSS = 45 Volts,
Vlim= 35 Volts.

Avant le temps T1, il n'y a pas de défaut d'intégrité de la gaine conductrice 280.

A partir du temps T1, la continuité de la gaine conductrice 280 est rompue.

Avant le temps T1, le signal V280 sur la gaine conductrice 280 est égal Vlim. Le signal de sortie Vcomp du comparateur 220a est donc dans son premier état, par exemple à 0 en logique Booléenne.

Passé T1, le signal V280 sur la gaine conductrice 280 est égal à la tension V_test_PSS de 45 Volts qui n'est plus limitée par le limiteur de tension 250a. Le signal V280 est supérieur à Vref. Le signal de sortie Vcomp du comparateur 220a passe donc de son premier état vers son second état.

Le microcontrôleur 220b envoie un signal au coupe-circuit 210 pour mettre le conducteur 240 hors tension. Après la durée T5b, la fourniture en énergie électrique est interrompue.

Grâce à la présente invention, dès qu'une rupture de continuité électrique de la gaine conductrice 280 est détectée, la fourniture en énergie électrique est interrompue après un bref temps de réaction des circuits électroniques. La gaine conductrice 280 polarisée en tension forme ainsi un détecteur capable de détecter la déconnexion ou rupture de la liaison électrique 290. La coupure rapide (quelques millisecondes) de l'énergie électrique sécurise les éventuelles interventions du personnel de maintenance en empêchant la survenue d'arc électrique lors d'une déconnexion de la liaison électrique de l'équipement utilisateur 250.

Dans la description ci-dessus, par ligne de retour de courant 260, on entend soit un conducteur de retour soit un réseau de retour de courant. Si la ligne de retour de courant 260 est un conducteur mis à une tension différente de celle de la structure conductrice de l'aéronef, alors un dispositif de protection électrique tel que décrit plus haut devra être associé à la ligne de retour de courant 260 pour sécuriser le retour de courant.

L'invention a été décrite pour protéger la transmission d'énergie électrique via une liaison électrique d'une installation électrique d'un aéronef 10. Cependant, l'invention trouve application à tout autre type de véhicule, par exemple un navire ou une automobile.

## Revendications

1. Liaison électrique (290) adaptée à relier une source d'énergie haute tension à courant continu (270) à un équipement utilisateur (250), la liaison électrique comprenant un conducteur électrique (240) entouré d'une enveloppe isolante (320), la liaison électrique (290) comprenant un dispositif de protection (200) électrique comprenant :
- une gaine conductrice (280) arrangée autour de l'enveloppe isolante (320),
- un coupe-circuit (210) arrangé sur le conducteur électrique (240) et configuré pour couper un courant transitant via ledit conducteur,
**caractérisé en ce que** le dispositif de protection (200) comprend en outre ;
- un module de polarisation, situé du côté de la source d'alimentation électrique (270), configuré pour polariser en tension la gaine conductrice (280) avec une tension continue (V_test_PSS), dite tension de test ;
- un dispositif de limitation (250a) de la tension de polarisation de la gaine, arrangé dans le équipement utilisateur, ayant une tension de limitation (Vlim) inférieure à la tension de test (V_test_PSS) ;
- un module de détection (220) connecté à la gaine conductrice (280) et configuré pour détecter une limitation ou non de la tension de polarisation de la gaine conductrice par le dispositif de limitation (250a) et pour commander le coupe-circuit (210) en fonction de la détection.

2. Liaison selon la revendication 1, **caractérisée en ce que** le module de polarisation comprend une source de tension continue (245a) fournissant la tension de test (V_test_PSS) connectée à la gaine conductrice (280).

3. Liaison (290) selon la revendication 2, **caractérisée en ce que** le module de détection (220) comprend :
- un comparateur (220a) dont une première entrée est connectée à la gaine conductrice (280) et dont une seconde entrée est connectée à un générateur de tension continue fournissant une tension dite de référence (Vref) ;
- un microcontrôleur (220b) connecté entre une sortie du comparateur (220) et le coupe-circuit (210), le microcontrôleur étant configuré pour envoyer un signal de commande au coupe-circuit en fonction d'un signal de sortie reçu du comparateur (220a).

4. Liaison (290) selon l'une quelconque des revendications 1 à 3, **caractérisée en ce qu'**une enveloppe isolante (310) entoure la gaine conductrice (280).

## Patentansprüche

1. Elektrische Verbindung (290), die dafür ausgelegt ist, eine Gleichstrom-Hochspannungsenergiequelle (270) mit einer Benutzereinrichtung (250) zu verbinden, wobei die elektrische Verbindung einen elektrischen Leiter (240) umfasst, der von einer isolierenden Umhüllung (320) umgeben ist, wobei die elektrische Verbindung (290) eine elektrische Schutzvorrichtung (200) umfasst, welche umfasst:
- eine leitende Hülle (280), die um die isolierende Umhüllung (320) herum angeordnet ist,
- einen Stromunterbrecher (210), der an dem elektrischen Leiter (240) angeordnet ist und dafür ausgelegt ist, einen durch den Leiter fließenden Strom zu unterbrechen,
**dadurch gekennzeichnet, dass** die Schutzvorrichtung (200) außerdem umfasst:
- ein Vorspannungsmodul, das sich auf der Seite der Stromversorgungsquelle (270) befindet und dafür ausgelegt ist, die leitende Hülle (280) mit einer Gleichspannung (V_test _PSS), Prüfspannung genannt;
- eine Vorrichtung zur Begrenzung (250a) der Vorspannung der Hülle, die in der Benutzereinrichtung angeordnet ist und eine Begrenzungsspannung (Vlim) aufweist, die niedriger als die Prüfspannung (V_test_PSS) ist;
- ein Detektionsmodul (220), das mit der leitenden Hülle (280) verbunden ist und dafür ausgelegt ist zu detektieren, ob eine Begrenzung der Vorspannung der leitenden Hülle durch die Begrenzungsvorrichtung (250a) erfolgt oder nicht, und in Abhängigkeit von der Detektion den Stromunterbrecher (210) zu steuern.

2. Verbindung nach Anspruch 1, **dadurch gekennzeichnet, dass** das Vorspannungsmodul eine Gleichspannungsquelle (245a) umfasst, welche die Prüfspannung (V_test_PSS) liefert und mit der leitenden Hülle (280) verbunden ist.

3. Verbindung (290) nach Anspruch 2, **dadurch gekennzeichnet, dass** das Detektionsmodul (220) umfasst:
- einen Komparator (220a), von dem ein erster Eingang mit der leitenden Hülle (280) verbunden ist und von dem ein zweiter Eingang mit einem Gleichspannungsgenerator verbunden ist, der eine sogenannte Referenzspannung (Vref) liefert;
- einen Mikrocontroller (220b), der zwischen einen Ausgang des Komparators (220) und den Stromunterbrecher (210) geschaltet ist, wobei der Mikrocontroller dafür ausgelegt ist, in Abhängigkeit von einem von dem Komparator (220a) empfangenen Ausgangssignal ein Steuersignal an den Stromunterbrecher zu senden.

4. Verbindung (290) nach einem der Ansprüche 1 bis 3, **dadurch gekennzeichnet, dass** eine isolierende Umhüllung (310) die leitende Hülle (280) umgibt.

## Claims

1. Electrical link (290) designed to link a DC high-voltage power source (270) to a user apparatus (250), the electrical link comprising an electrical conductor (240) surrounded by an insulating cover (320), the electrical link (290) comprising an electrical protection device (200) comprising:
- a conductive sleeve (280) arranged around the insulating cover (320),
- a circuit breaker (210) arranged on the electrical conductor (240) and configured to cut off a current transiting through said conductor,
**characterized in that** the protection device (200) furthermore comprises:
- a biasing module, situated on the side of the electric power source (270), configured to voltage-bias the conductive sleeve (280) with a DC voltage (V_test_PSS), termed test voltage;
- a device (250a) for limiting the bias voltage of the conductive sleeve, arranged in the user apparatus, having a limit voltage (Vlim) lower than the test voltage (V_test_PSS);
- a detection module (220) connected to the conductive sleeve (280) and configured to detect a limiting, or lack thereof, of the bias voltage of the conductive sleeve by the limiting device (250a), and to command the circuit breaker (210) on the basis of the detection.

2. Link according to Claim 1, **characterized in that** the biasing module comprises a DC voltage source (245a) supplying the test voltage (V_test_PSS), connected to the conductive sleeve (280).

3. Link (290) according to Claim 2, **characterized in that** the detection module (220) comprises:
- a comparator (220a) whose first input is connected to the conductive sleeve (280) and whose second input is connected to a DC voltage generator supplying what is termed a reference voltage (Vref);
- a microcontroller (220b) connected between an output of the comparator (220) and the circuit breaker (210), the microcontroller being configured to send a command signal to the circuit breaker on the basis of an output signal received from the comparator (220a).

4. Link (290) according to any one of Claims 1 to 3, **characterized in that** an insulating cover (310) surrounds the conductive sleeve (280).
